(19) Europäisches Patentamt
European Patent Office
Office européen des brevets

(11) **EP 3 314 744 B1**

(12) **EUROPÄISCHE PATENTSCHRIFT**

(45) Veröffentlichungstag und Bekanntmachung des Hinweises auf die Patenterteilung:
**07.08.2019 Patentblatt 2019/32**

(21) Anmeldenummer: **16724434.2**

(22) Anmeldetag: **24.05.2016**

(51) Int Cl.:
*H02P 29/024* (2016.01)   *H02H 7/08* (2006.01)
*H02H 3/05* (2006.01)   *H02M 1/00* (2006.01)

(86) Internationale Anmeldenummer:
**PCT/EP2016/061669**

(87) Internationale Veröffentlichungsnummer:
**WO 2016/206896 (29.12.2016 Gazette 2016/52)**

(54) **VERFAHREN UND VORRICHTUNG ZUM PRÜFEN EINES ANTRIEBSSTROMS EINER ELEKTRISCHEN MASCHINE**

METHOD AND DEVICE FOR CHECKING A DRIVE CURRENT OF AN ELECTRIC MACHINE

PROCÉDÉ ET DISPOSITIF POUR TESTER UN COURANT DE FORCE MOTRICE D'UNE MACHINE ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.06.2015 DE 102015110174**

(43) Veröffentlichungstag der Anmeldung:
**02.05.2018 Patentblatt 2018/18**

(73) Patentinhaber: **Carl Zeiss Industrielle Messtechnik GmbH**
**73447 Oberkochen (DE)**

(72) Erfinder:
• **GRUPP, Guenter**
**89558 Boehmenkirch (DE)**
• **RUCK, Otto**
**73479 Pfahlheim (DE)**
• **UHL, Peter**
**73485 Unterschneidheim (DE)**
• **MAIER, Thomas**
**73431 Aalen (DE)**

(74) Vertreter: **Witte, Weller & Partner Patentanwälte mbB**
**Postfach 10 54 62**
**70047 Stuttgart (DE)**

(56) Entgegenhaltungen:
EP-A1- 2 063 333   DE-A1-102011 075 387
US-A1- 2005 218 849   US-A1- 2008 094 762

**Beschreibung**

Die vorliegende Erfindung betrifft ein Verfahren zum Prüfen eines Antriebsstroms einer elektrischen Maschine gemäß dem Oberbegriff von Anspruch 1, insbesondere einer elektrischen Maschine eines Koordinatenmessgeräts, wobei die elektrische Maschine einen elektrischen Antrieb mit einem Ständer und einem Läufer aufweist.

Die Erfindung betrifft ferner eine Vorrichtung zum Prüfen eines Antriebsstroms einer elektrischen Maschine gemäß dem Oberbegriff von Anspruch 12, insbesondere einer elektrischen Maschine eines Koordinatenmessgeräts, wobei die elektrische Maschine einen elektrischen Antrieb mit einem Ständer und einem Läufer aufweist.

Ein solches Verfahren und eine solche Vorrichtung sind aus EP 2 063 333 A1 bekannt.

Die vorliegende Erfindung betrifft ferner ein Verfahren zum Betreiben einer elektrischen Maschine unter Einbindung des vorgenannten Verfahrens sowie eine elektrische Maschine mit einer vorgenannten Vorrichtung.

Auf dem technischen Gebiet von elektrischen Antrieben ist es allgemein bekannt, dass der Motorstrom als elektrische Größe proportional ist zu einer Motorkraft für Linearmotoren und einem Motordrehmoment für rotatorische Motoren. Der Zusammenhang zwischen dieser elektrischen Größe und der mechanischen Größe ist durch eine antriebsspezifische Kenngröße gegeben. Zur präzisen und sicheren Steuerung von elektrischen Antrieben ist es daher notwendig, den Motorstrom als Messgröße zur Bestimmung bzw. zur Begrenzung von Motorkräften bzw. Motordrehmomenten zuverlässig zu erfassen und für die Steuerung des Motors bereitzustellen. Für eine derartige zuverlässige Messung des Motorstroms ist es üblicherweise notwendig, den Motorstrom redundant zu erfassen, um das entsprechende Sicherheitsniveau zu erreichen.

Ein entsprechender elektrischer Antrieb für ein Koordinatenmessgerät, bei dem die Geschwindigkeit und/oder die Beschleunigung des Läufers auf der Grundlage des erfassten Motorstroms gesteuert bzw. begrenzt wird, ist beispielsweise aus der DE 10 2006 003 362 A1 bekannt.

Der Motorstrom von Gleichstrommotoren wird üblicherweise durch einen Nebenwiderstand in der Motorleitung oder durch einen Hall-Sensor erfasst und kann zusätzlich in der zentralen Steuerung redundant erfasst werden, so dass mit geringem Aufwand eine redundante Motorstrommessung möglich ist.

Die heute häufig verwendeten elektrisch kommutierten Gleichstrommaschinen (BLDC) weisen üblicherweise drei Phasen auf, die 120° zueinander versetzt sind, wobei in mindestens zwei der drei Phasen, vorzugsweise jedoch in allen drei Phasen der Motorstrom erfasst wird, um das Drehmoment des Antriebs zu bestimmen bzw. zu begrenzen. Für die Bestimmung des Drehmoments ist dabei jedoch eine technisch aufwendige Transformation der drei Phasenströme notwendig.

Da bei den mehrphasigen elektrisch kommutierten Gleichstrommaschinen die Erfassung des wirksamen Motorstroms technisch aufwendig und kompliziert ist, weisen die meisten derartigen Antriebe keine redundante Erfassung des Motorstroms auf, so dass für sicherheitsrelevante Anwendungen keine entsprechend zuverlässige Messung möglich ist.

Ferner erfolgt bei dezentraler Anordnung der Steuereinheit die Steuerung des elektrischen Antriebs üblicherweise über ein digitales Bussystem. Für eine sichere Motorsteuerung müssen die erfassten Motorströme jedoch zuverlässig über das digitale Bussystem an die zentrale Steuerung übertragen werden, so dass die Übertragung des Messwertes des Motorstroms an die zentrale Steuerung im Allgemeinen mit hohem technischen Aufwand verbunden ist.

Die eingangs genannte EP 2 063 333 A1 offenbart die Überwachung eines elektrischen Antriebsmotors für ein Hybrid-Kfz. Dabei werden zwei Vergleichswerte in Form von Motormomenten berechnet. Zum einen wird das Motormoment aus den Phasenströmen des Motors berechnet, die letztlich den Antriebsstrom bilden. Zum anderen wird das Motormoment aus den eingangsseitig anliegenden Größen Batteriespannung und Batteriestrom bestimmt.

DE 10 2001 075 387 A1 beschreibt einen ähnlichen Stand der Technik, ebenfalls für einen Kfz-Motor. Auch hier wird das Motormoment auf zwei verschiedene Arten berechnet und zur Überwachung herangezogen.

US 2005/0218849 schlägt die Überwachung des Motorstroms anhand eines Referenzwertes vor, der mit dem Motorstrom verglichen wird.

US 2008/0094762 A1 schlägt zwei redundante Sensorkreise zur Erfassung der Motorströme vor.

Es ist Aufgabe der vorliegenden Erfindung, eine Absicherung des erfassten Motorstroms für einen elektrischen Antrieb mit technisch geringem Aufwand bereitzustellen.

Gemäß einem ersten Aspekt der vorliegende Erfindung wird daher ein Verfahren gemäß Anspruch 1 vorgeschlagen.

Gemäß einem zweiten Aspekt der vorliegenden Erfindung wird daher eine Vorrichtung gemäß Anspruch 12 vorgeschlagen.

Es wird ferner ein Verfahren zum Betreiben einer elektrischen Maschine bereitgestellt, das die Schritte Prüfen des Antriebsstroms der elektrischen Maschine gemäß der vorliegenden Erfindung und Unterbrechen einer elektrischen Energieversorgung des elektrischen Antriebs, sofern der Vergleichswert einen vordefinierten Schwellenwert überschreitet, aufweist.

Es wird schließlich eine elektrische Maschine der eingangs genannten Art bereitgestellt mit einer Vorrichtung

**EP 3 314 744 B1**

zum Prüfen des Antriebsstroms der elektrischen Maschine gemäß der vorliegenden Erfindung.

Erfindungsgemäß wird unter einem Leistungsmodell der elektrischen Maschine eine Betrachtung der aufgenommenen und abgegebenen Leistungen unter Berücksichtigung der Energiehaltung verstanden.

Unter einer elektrischen Eingangsgröße der elektrischen Maschine wird gemäß der vorliegenden Erfindung eine elektrische Eingangsspannung oder ein elektrischer Eingangsstrom der gesamten elektrischen Maschine verstanden, wobei die elektrische Eingangsgröße wenigstens eine elektrische Größe der von der elektrischen Maschine aufgenommenen elektrischen Leistung bildet.

Durch das erfindungsgemäße Verfahren und die erfindungsgemäße Vorrichtung wird der Antriebsstrom, der zum Antreiben des Läufers dem elektrischen Antrieb zugeführt wird, erfasst und auf der Grundlage des erfassten Antriebsstroms und einer Betrachtung der von der elektrischen Maschine aufgenommenen elektrischen Leistung die elektrische Eingangsgröße berechnet, so dass der gemessene Antriebsstrom durch einen Vergleich des Berechnungswerts der elektrischen Eingangsgröße mit dem Messwert der elektrischen Eingangsgröße abgesichert werden kann. Durch diesen Vergleich der gemessenen elektrischen Eingangsgröße und der auf der Grundlage des Antriebsstroms berechneten elektrischen Eingangsgröße kann der Antriebsstrom messtechnisch überprüft werden, so dass eine zusätzliche Redundanz mit technisch geringem Aufwand bereitgestellt werden kann und die Zuverlässigkeit der Motorstrommessung dadurch erhöht werden kann. Durch das erfindungsgemäße Verfahren und die erfindungsgemäße Vorrichtung wird der Antriebsstrom mit einem gewissen Unsicherheitsfaktor erfasst und kann durch die theoretische Leistungsbetrachtung und die Messung der elektrischen Eingangsgröße durch einen zweiten Messwert geprüft werden, so dass mit technisch geringem Aufwand eine Absicherung des gemessenen Wertes des Antriebsstroms möglich ist. Der Vergleichswert wird auf der Grundlage eines Differenzwerts zwischen dem Messwert und dem Berechnungswert der elektrischen Eingangsgröße bestimmt. Dadurch kann mit technisch geringem Aufwand eine Abweichung des erfassten Wertes des Antriebsstroms von einem erwarteten Wert des Antriebsstroms ermittelt werden, so dass mit technisch geringem Aufwand eine fehlerhafte Messung erkannt werden kann.

Durch die so abgesicherte Messung des Motorstroms kann eine sichere und zuverlässige Vorschubkraftbegrenzung für Linearantriebe und eine sichere und zuverlässige Antriebsmomentbegrenzung erzielt werden, so dass mit technisch geringem Aufwand ein ausreichendes Sicherheitsniveau für Personenschutz oder dgl. bereitgestellt werden kann.

Schließlich kann durch die Absicherung des Motorstroms über die theoretische Leistungsbetrachtung und die mit technisch geringem Aufwand äußerlich messbare elektrische Eingangsgröße der elektrischen Maschine der technische Aufwand zur zuverlässigen Übertragung des abgesicherten Motorstroms erheblich reduziert werden, da die Absicherung des Messwerts über das Leistungsmodell in der zentralen Steuereinheit erfolgen kann.

Dadurch, dass bei dem erfindungsgemäßen Verfahren zum Betreiben einer elektrischen Maschine die elektrische Energieversorgung des elektrischen Antriebs unterbrochen wird, sofern der Vergleichswert einen vordefinierten Schwellenwert überschreitet, kann eine fehlerhafte Messung des Antriebsstroms erkannt werden und der elektrische Antrieb zuverlässig abgeschaltet werden, wenn die Begrenzung der Vorschubkraft bzw. die Begrenzung des Drehmoments nicht mehr zuverlässig gewährleistet werden kann. Die zuverlässige Funktion und die Sicherheit der elektrischen Maschine kann somit deutlich erhöht werden.

Die elektrische Eingangsgröße ist ein von der elektrischen Maschine aufgenommener Gesamtstrom oder eine dem von der elektrischen Maschine aufgenommenen Gesamtstrom entsprechende elektrische Größe.

Dadurch ist es möglich, eine in Abhängigkeit der elektrischen Leistungsaufnahme der elektrischen Maschine variierende elektrische Größe mit technisch geringem Aufwand zu erfassen.

Dabei ist es besonders bevorzugt, wenn eine elektrische Spannung an einem Messwiderstand einer elektrischen Eingangsleitung der elektrischen Maschine erfasst wird, um den von der elektrischen Maschine aufgenommenen Gesamtstrom zu messen.

Dadurch kann mit technisch geringem Aufwand der von der elektrischen Maschine aufgenommene Gesamtstrom erfasst werden.

Es ist weiterhin bevorzugt, wenn der Berechnungswert der elektrischen Eingangsgröße auf der Grundlage einer der elektrischen Maschine bereitgestellten Gesamtspannung berechnet wird.

Dadurch kann die gesamte von der elektrischen Maschine aufgenommene elektrische Leistung präzise bestimmt werden.

In einer bevorzugten Ausführungsform berücksichtigt das Leistungsmodell eine elektromotorische Kraft oder eine elektromagnetische Gegenkraft des elektrischen Antriebs.

Dadurch kann die von dem elektrischen Antrieb aufgenommene und nicht in Bewegungsenergie umgewandelte elektrische Leistung berücksichtigt werden, wodurch die Leistungsbetrachtung über das Leistungsmodell besonders präzise möglich ist.

Dabei ist es besonders bevorzugt, wenn eine Bewegungsgröße des Läufers erfasst wird und die elektromotorische Kraft oder die elektromagnetische Gegenkraft auf der Grundlage einer Kenngröße des elektrischen Antriebs und der erfassten Bewegungsgröße bestimmt wird.

Dadurch kann die elektromotorische Kraft oder die elektromagnetische Gegenkraft unabhängig von den elektrischen Eingangsgrößen bestimmt werden.

In einer besonderen Ausführungsform berücksichtigt das Leistungsmodell eine elektrische Verlustleistung einer Steuereinheit der elektrischen Maschine.

Dadurch können zusätzliche elektrische Verbraucher der elektrischen Maschine im Leistungsmodell berücksichtigt werden, wodurch die Leistungsbetrachtung noch präziser möglich ist.

Es ist dabei besonders bevorzugt, wenn die elektrische Verlustleistung der Steuereinheit bei stillstehendem Läufer bestimmt wird.

Die elektrische Verlustleistung der Steuereinheit bei stillstehendem Läufer wird dabei bestimmt über die Stromaufnahme bei stillstehendem Läufer, wobei die aufgenommene elektrische Leistung im bewegten Betrieb auf der Grundlage der Versorgungsspannung der elektrischen Maschine und der Stromaufnahme bei stillstehendem Antrieb ermittelt wird. Dadurch kann die Leistungsaufnahme der Steuereinheit mit technisch geringem Aufwand zuverlässig bestimmt werden.

Es ist weiterhin bevorzugt, wenn das Leistungsmodell eine mechanische Antriebsleistung des elektrischen Antriebs berücksichtigt. Die mechanische Antriebsleistung ergibt sich dabei vorzugsweise aus dem wirksamen Antriebsstrom, der von dem Läufer des elektrischen Antriebs aufgenommen wird und dem elektrischen Widerstand des Läufers, der als Motorkonstante gegeben ist oder vorab bestimmt werden kann.

Dadurch kann die mechanische Antriebsleistung als Komponente des Leistungsmodells mit technisch geringem Aufwand auf der Grundlage des gemessenen Antriebsstroms bestimmt werden.

Es ist weiterhin bevorzugt, wenn der Vergleichswert auf der Grundlage einer Summe einer Mehrzahl der Differenzwerte bestimmt wird.

Dadurch können durch die entsprechende Mittelwertbildung kleinere kurzzeitige Differenzen zwischen dem gemessenen Antriebsstrom und dem berechneten Vergleichswert ausgeglichen werden, so dass kurzzeitige Differenzen nicht zur Abschaltung der elektrischen Maschine führen.

Es ist weiterhin bevorzugt, wenn der Vergleichswert auf der Grundlage eines Integrals des Differenzwerts bestimmt wird.

Dadurch kann eine kontinuierliche präzise Mittelwertbildung des Differenzwerts durchgeführt werden.

Es ist dabei besonders bevorzugt, wenn ein vordefinierter Wert von einem Wert des Integrals oder einem Wert der Summe subtrahiert wird.

Dadurch kann mit technisch geringem Aufwand ein maximaler Grenzwert für die Gesamtdifferenz zwischen dem Antriebsstrom und dem Vergleichswert definiert werden, so dass ein Fehler in der Motorstromerfassung zuverlässig erkannt werden kann.

In einer bevorzugten Ausführungsform ist die zweite Erfassungseinheit zum Erfassen des Messwertes der elektrischen Eingangsgröße und die Bestimmungseinheit zum Bestimmen des Berechnungswertes der elektrischen Eingangsgröße jeweils mit einer separaten Prüfeinheit verbunden, wobei die Prüfeinheiten jeweils dazu ausgebildet sind, den Vergleichswert unabhängig zu bestimmen, um den erfassten Wert des Antriebsstroms unabhängig zu prüfen. Die beiden Prüfeinheiten tauschen dabei vorzugsweise die gemessenen und berechneten Daten untereinander aus, um der jeweils anderen Prüfeinheit die notwendigen Daten zur Verfügung zu stellen.

Dadurch kann eine unabhängige Prüfung des Antriebsstroms erfolgen, wodurch die Zuverlässigkeit der Prüfung des Antriebsstroms weiterhin erhöht werden kann.

In einer bevorzugten Ausführungsform sind die separaten Prüfeinheiten jeweils mit einer Schalteinheit der elektrischen Maschine verbunden, um die elektrische Energieversorgung des elektrischen Antriebs zu unterbrechen. Dabei sind die Schalteinheiten der elektrischen Maschine separat ausgebildet und unabhängig voneinander betätigbar.

Dadurch kann im Falle eines Fehlers in der Motorstromerfassung die elektrische Maschine bzw. der elektrische Antrieb zuverlässig und unabhängig abgeschaltet werden.

Insgesamt kann durch die vorliegende Erfindung mit technisch geringem Aufwand eine zuverlässige Überprüfung der Messung des Antriebsstroms erfolgen, wobei der so gemessene und geprüfte Antriebsstrom mit technisch geringem Aufwand einer zentralen Steuereinheit zur Verfügung gestellt werden kann, da die Prüfung separat von der Messung des Antriebsstroms erfolgt und die elektrische Eingangsgröße äußerlich an der elektrischen Energieversorgung der elektrischen Maschine erfasst werden kann. Über das Leistungsmodell können die unterschiedlichen elektrischen Energien in Form einer Energieerhaltungsbetrachtung berücksichtigt werden und die physikalischen Größen der einzelnen Energiekomponenten separat ermittelt werden, so dass eine präzise Berechnung der elektrischen Eingangsgröße als Referenz erfolgen kann.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:

Fig. 1    eine schematische Darstellung einer elektrischen Maschine mit einer Steuereinheit zum Ansteuern eines elektrischen Antriebs und mit einer Vorrichtung zum Prüfen einer elektrischen Größe der elektrischen Maschine,

Fig. 2    eine schematische Detailzeichnung einer Ausführungsform der elektrischen Maschine aus Fig. 1,

Fig. 3    ein schematisches Flussdiagramm eines Verfahrens zum Prüfen einer elektrischen Größe der elektrischen Maschine, und

Fig. 4    eine schematische Darstellung einer Ausführungsform eines Koordinatenmessgeräts als Anwendungsbeispiel für die elektrische Maschine aus Fig. 1.

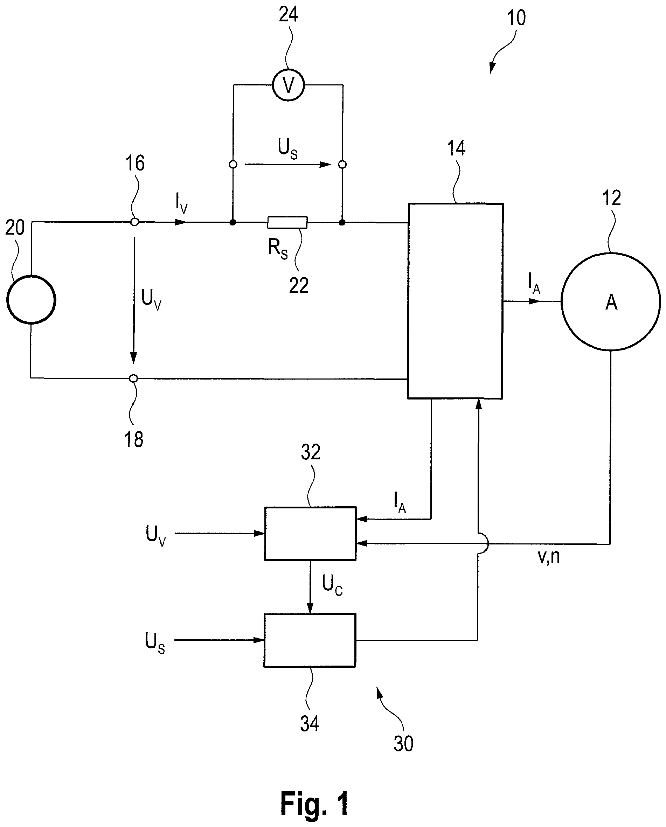

In Fig. 1 ist eine elektrische Maschine schematisch dargestellt und allgemein mit 10 bezeichnet. Die elektrische Maschine 10 weist einen elektrischen Antrieb 12 und eine Steuereinheit 14 zum Ansteuern bzw. zum Bestromen des elektrischen Antriebs 12 auf. Der elektrische Antrieb 12 kann im Allgemeinen als rotatorischer Motor oder als Linearmotor ausgebildet sein und weist im Allgemeinen einen feststehenden Ständer und einen beweglichen Läufer auf, wobei je nach Ausführungsform der Läufer ein Drehmoment oder eine lineare Motorkraft bereitstellt. Die Steuereinheit 14 ist elektrisch mit dem Ständer des elektrischen Antriebs 12 verbunden und steuert den elektrischen Antrieb 12 an bzw. bestromt den elektrischen Antrieb 12 mittels eines Motorstroms $I_A$. Das von dem Läufer bereitgestellte Drehmoment bzw. die von dem Läufer bereitgestellte Motorkraft ist proportional zu dem Motorstrom $I_A$, so dass das Drehmoment bzw. die Motorkraft entsprechend über den Motorstrom $I_A$ gesteuert bzw. begrenzt werden kann.

Die Steuereinheit 14 ist mit elektrischen Eingangsanschlüssen 16, 18 der elektrischen Maschine 10 verbunden, um die Steuereinheit 14 mit einer externen Spannungsquelle 20 elektrisch zu verbinden, die an den Eingangsanschlüssen 16, 18 eine Eingangsspannung bzw. eine Versorgungsspannung $U_V$ bereitstellt. Die Steuereinheit 14 nimmt je nach Antriebsleistung des elektrischen Antriebs 12 einen Eingangsstrom $I_V$ auf, der einen aufgenommenen Gesamtstrom $I_V$ der elektrischen Maschine 10 bildet. In einer Eingangsleitung, die einen der elektrischen Anschlüsse 16, 18 mit der Steuereinheit 14 verbindet, ist ein Messwiderstand 22 mit einem elektrischen Widerstand $R_S$ angeordnet, wobei an dem Messwiderstand 22 eine Messspannung $U_S$ abfällt, die zur Bestimmung des aufgenommenen Gesamtstroms $I_V$ mittels eines Voltmeters 24 erfasst wird.

Eine Vorschubkraft F des Läufers des elektrischen Antriebs 12 bzw. ein Drehmoment M des Läufers ist über eine Motorkraftkonstante bzw. eine Drehmomentkonstante direkt proportional zum Motorstrom $I_A$. Der Motorstrom $I_A$ kann von der Steuereinheit 14 oder einem separaten Amperemeter gemessen bzw. erfasst werden und steht als nicht abgesicherter Messwert zur Verfügung. Sofern mit Hilfe des Motorstroms $I_A$ die Vorschubkraft F oder das Drehmoment M sicher bestimmt bzw. sicher begrenzt werden soll, muss die Messung des Motorstroms $I_A$ entsprechend durch eine weitere Messung abgesichert werden, wie es im Weiteren näher erläutert ist.

Der elektrische Antrieb 12 kann im Allgemeinen als elektrischer Linearmotor, als mechanisch kommutierter Gleichstrommotor oder als bürstenloser elektrisch kommutierter Gleichstrommotor (BLDC) ausgebildet sein.

Zur Absicherung des erfassten Motorstroms $I_A$ weist die elektrische Maschine 10 eine Vorrichtung 30 zum Prüfen des Motorstroms $I_A$ als elektrische Größe der elektrischen Maschine 10 auf. Die Vorrichtung 30 zum Prüfen des Motorstroms $I_A$ weist eine Bestimmungseinheit 32 auf, die auf der Grundlage des erfassten Motorstroms $I_A$, der Eingangsspannung $U_V$ und einer Bewegungsgröße v, n des Läufers und auf Grundlage eines Leistungsmodells der elektrischen Maschine 10 einen Berechnungswert $U_C$ für die Messspannung $U_S$ bestimmt. Die Vorrichtung 30 zum Prüfen des Motorstroms $I_A$ weist ferner eine Prüfeinheit 34 auf, die den Berechnungswert $U_C$ für die Messspannung $U_S$ und den Messwert der Messspannung $U_S$ vergleicht, um den erfassten Wert des Antriebsstroms $I_A$ zu prüfen. Die Prüfeinheit 34 gibt einen Vergleichswert zwischen dem Berechnungswert $U_C$ und der Messspannung $U_S$ aus und kann auf der Grundlage des Vergleichswerts eine Abschaltung der elektrischen Maschine 10 im Allgemeinen oder eine Abschaltung der Steuereinheit 14, wie es in Fig. 1 dargestellt ist, durchführen.

Die Vorrichtung 30 zum Prüfen des Motorstroms $I_A$ kann als integrierte Schaltung in einem Chip in Form eines Mikrocontrollers ausgebildet sein.

Da die Bestimmungseinheit 32 den Berechnungswert $U_C$ aus dem Motorstrom $I_A$ sowie der Eingangsspannung $U_V$ und der Bewegungsgröße v, n des Läufers bestimmt, also auf der Grundlage von Messgrößen, die von der gemessenen Messspannung $U_S$ unabhängig sind, ist der Berechnungswert $U_C$ unabhängig von der Messspannung $U_S$, so dass ein Vergleich von zwei redundanten Messgrößen möglich ist und so die Messung des Motorstroms $I_A$ abgesichert werden kann.

Das Leistungsmodell der elektrischen Maschine 10 basiert auf dem Prinzip der Energieerhaltung, dass eine elektrische Eingangsleistung $P_V$ der elektrischen Maschine 10 identisch ist mit einer Summe einer abgegebenen mechanischen Antriebsleistung $P_{mech}$, einer Verlustleistung $P_M$ des Motors sowie einer Verlustleistung $P_E$ der elektronischen Komponenten der elektrischen Maschine 10, wie es in Formel 1 gezeigt ist:

$$P_V = P_{mech} + P_M + P_E \qquad \text{(Formel 1)}$$

Die elektrische Eingangsleistung $P_V$ kann mit Hilfe des Messwiderstands 22 und der Eingangsspannung $U_V$ nach Formel 2:

$$P_V = U_V * I_V \qquad \text{(Formel 2)}$$

berechnet werden. Die Eingangsspannung $U_V$ sowie der Gesamtstrom $I_V$ kann alternativ über eine zentrale Steuereinheit im Bereich der Eingangsanschlüsse 16, 18 erfasst werden. Weiterhin kann an einer beliebigen Position der elektrischen Verbindungsleitung der Steuereinheit 14 der Gesamtstrom $I_V$ oder die Messspannung $U_S$ durch eine separate Messeinheit ermittelt werden, die die entsprechenden Messergebnisse über eine digitale Busleitung der zentralen Steuereinheit bereitstellen.

Die elektrische Verlustleistung $P_E$ bzw. die Eigenverbrauchsleistung $P_E$ der elektronischen Komponenten der elektrischen Maschine 10 wie beispielsweise der Steuereinheit 14 kann bei stillstehendem Läufer vorab gemessen werden, wobei dann der aufgenommene Gesamtstrom $I_V$ identisch ist mit dem elektrischen Strom $I_E$, der von den elektronischen Komponenten aufgenommen wird. Die elektrische Verlustleistung $P_E$ der elektronischen Komponenten ergibt sich aus Formel 3:

$$P_E = U_V * I_E \qquad \text{(Formel 3)}$$

Die Verlustleistung des Motors $P_M$ ergibt sich aus dem Motorstrom $I_A$, der durch den Läufer bzw. einen Anker des Läufers fließt, wobei der Anker des Läufers einen Ankerwiderstand $R_A$ aufweist. Die Verlustleistung des Motors $P_M$ ergibt sich aus Formel 4:

$$P_M = R_A \cdot I_A^2 \qquad \text{(Formel 4)}$$

wobei der Ankerwiderstand $R_A$ eine bekannte Motorkonstante ist und der Motorstrom $I_A$ wie oben erläutert von der Steuereinheit 14 oder einem zugeordneten Amperemeter gemessen werden kann.

Zusätzlich zu der Verlustleistung des Motors $P_M$ und der Verlustleistung $P_E$ der elektronischen Komponenten muss auch die eigentliche Motorleistung bzw. die mechanische Vorschubleistung $P_{Mech}$ berücksichtigt werden, die aus einer zur Drehzahl bzw. Geschwindigkeit proportionalen Komponente und aus einer zum Drehmoment bzw. zur Kraft proportionalen Komponente besteht. Die zur Drehzahl bzw. Geschwindigkeit proportionale Komponente $U_{EMK}$, entspricht der elektromotorischen Kraft (gegen EMK) und kann mit einer Motorkonstante $K_{EMK}$, die für jeden elektrischen Antrieb bekannt oder messbar ist und der Geschwindigkeit v des Läufers bzw. einer Drehzahl n des Läufers als Bewegungsgröße des elektrischen Antriebs 12 berechnet werden. Die maximale Geschwindigkeit eines elektrischen Antriebs 12 ergibt sich dadurch, dass die elektromagnetische Gegenspannung $U_{EMK}$ einen Wert der maximal zur Verfügung stehenden Spannung, d.h. der Zwischenkreisspannung erreicht.

$$U_{EMK} = K_{EMK} * v; \; U_{EMK} = K_{EMK} * n \qquad \text{(Formel 5)}$$

Die zum Drehmoment bzw. zur Kraft proportionalen Komponente entspricht dem Motorstrom $I_A$ . Somit ergibt sich die eigentliche Motorleistung bzw. die mechanische Vorschubleistung $P_{Mech}$ durch Formel 6:

$$P_{mech} = U_{EMK} * I_A \qquad \text{(Formel 6)}$$

Damit ergibt sich für das Leistungsmodell aus Formel 1:

$$U_V * I_V = U_V * I_E + R_A * I_A^2 + K_{EMK} * v * I_A \qquad \text{(Formel 7)}$$

Für den statischen Fall, dass der Läufer stillsteht und daher keine mechanische Leistung abgegeben wird, ergibt sich für den Motorstrom:

$$I_A = \sqrt{U_V \cdot (I_V - I_E)/R_A} \qquad\qquad \text{(Formel 8)}$$

und für den dynamischen Fall unter Berücksichtigung mechanisch abgegebenen Leistung $P_{Mech}$ für den Gesamtstrom $I_V$:

$$I_V = (U_V \cdot I_E + R_A \cdot I_A^2 + K_{EMK} \cdot v \cdot I_A)/U_V \qquad\qquad \text{(Formel 9)}$$

wobei der Berechnungswert $U_C$ berechnet werden kann über den Widerstand $R_S$ des Messwiderstands 22:

$$U_C = R_S * I_V \qquad\qquad \text{(Formel 10)}$$

Über den Vergleichswert zwischen dem Berechnungswert $U_C$ und der Messspannung $U_S$ kann der gemessene Motorstrom $I_A$ unabhängig bzw. redundant geprüft werden, da der Berechnungswert $U_C$ auf dem Motorstrom $I_A$ und unabhängigen Größen basiert und die Messspannung $U_S$ an dem Messwiderstand 22 messtechnisch erfasst werden kann. Somit kann über das Leistungsmodell die einfache Messung des Motorstroms $I_A$ abgesichert werden und für sicherheitsrelevante Anlagen und Größen wie z.B. Begrenzung der Vorschubkraft verwendet werden.

Sofern der Differenzwert zwischen dem Berechnungswert $U_C$ und der Messspannung $U_S$ einen vordefinierten Wert überschreitet, ist die Messung des Motorstroms $I_A$ fehlerhaft, so dass der gemessene Motorstrom $I_A$ zur Absicherung der Vorschubkraft bzw. zur Absicherung des Antriebsmoments nicht mehr verwendet werden kann. In diesem Fall kann die elektrische Maschine 10 im Allgemeinen über die Steuereinheit 14 oder einen separaten Schalter oder Schütz abgeschaltet werden.

Da üblicherweise zwischen dem Berechnungswert $U_C$ und der Messspannung $U_S$ häufig kleinere Differenzen kurzzeitig auftreten, kann der Differenzwert gemittelt werden und zum Erkennen eines Fehlers kann der Differenzwert aufsummiert oder aufintegriert werden. Ferner kann von dem berechneten Summenwert oder berechneten Integralwert regelmäßig bzw. kontinuierlich ein vordefinierter Wert subtrahiert werden, so dass ein Fehler bei der Motorstromerfassung erst nach Erreichen eines Grenzwerts erkannt wird.

Alternativ dazu kann auch eine gleitende Mittelwertbildung mit einem Toleranzband oder dgl. durchgeführt werden.

Es versteht sich, dass die Messung des Gesamtstroms $I_V$ über den Messwiderstand 22 auch erfolgen kann, sofern eine Mehrzahl von Steuereinheiten 14 über den Messwiderstand 22 mit dem Eingangsanschluss 16 verbunden sind.

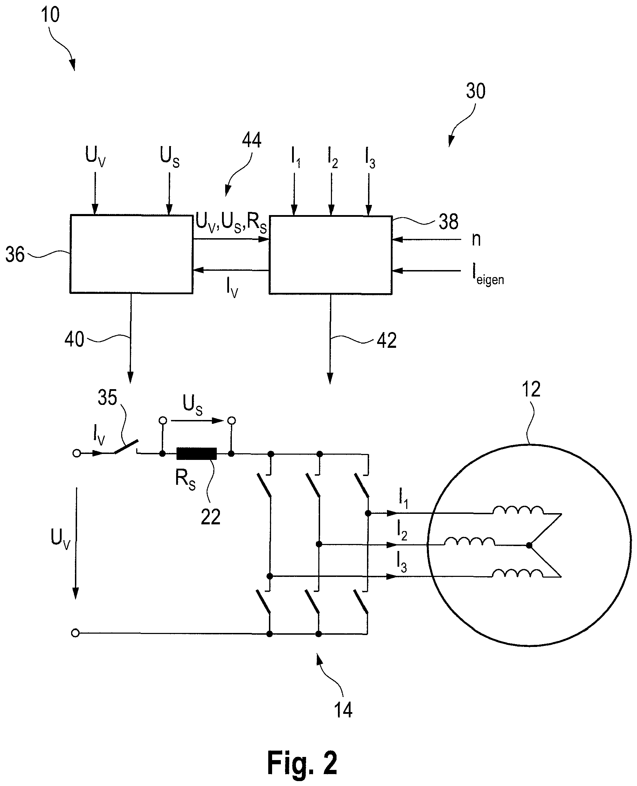

In Fig. 2 ist eine Ausführungsform der elektrischen Maschine 10 schematisch dargestellt. Gleiche Elemente sind mit gleichen Bezugszeichen bezeichnet, wobei hier lediglich die Besonderheiten erläutert sind.

Der elektrische Antrieb 12 ist in dieser Ausführungsform als elektrisch kommutierte Gleichstrommaschine ausgebildet, die drei Phasen U, V, W aufweist. Die Steuereinheit 14 ist als dreiphasiger Wechselrichter ausgebildet, der drei Halbbrücken mit jeweils zwei steuerbaren Schaltern aufweist, um die Eingangsspannung $U_V$ in eine dreiphasige Wechselspannung umzurichten. Die Steuereinheit 14 ist über drei Anschlussleitungen mit den drei Phasen des elektrischen Antriebs 12 verbunden und stellt entsprechend drei Phasenströme $I_1$, $I_2$ $I_3$ bereit, um den Läufer des elektrischen Antriebs 12 anzutreiben.

Die elektrische Maschine 10 weist ferner eine erste Prüfeinheit 36 und eine zweite Prüfeinheit 38 auf, die separat ausgebildet und vorzugsweise jeweils als integrierte Schaltung in Form eines Mikrocontrollers ausgebildet sind. Die erste Prüfeinheit 36 und die zweite Prüfeinheit 38 bilden zusammen die Vorrichtung 30.

Der ersten Prüfeinheit 36 werden als gemessene Eingangsgrößen die Messspannung $U_S$ und die Eingangsspannung $U_V$ bereitgestellt. Der zweiten Prüfeinheit 38 werden als Eingangsgrößen von der ersten Prüfeinheit die Eingangsspannung $U_V$, der Widerstand $R_S$ des Messwiderstands 22 sowie die Messspannung $U_S$ als Eingangsgrößen bereitgestellt. Ferner erhält die zweite Prüfeinheit Messwerte der drei Phasenströme $I_1$, $I_2$, $I_3$ sowie die Drehzahl n und die vorab ermittelte Stromaufnahme $I_E$ als weitere Eingangsgrößen. Die zweite Prüfeinheit 38 berechnet den Gesamtstrom $I_V$ wie oben erläutert anhand der Formel 9 auf Grundlage der Eingangsgrößen und berechnet ferner den Berechnungswert $U_C$ mittels des Widerstandswerts $R_S$ des Messwiderstands 22 und vergleicht die gemessene Messspannung $U_S$ mit dem so ermittelten Berechnungswert $U_C$. Die zweite Prüfeinheit 38 ist über eine Signalleitung 42 mit der Steuereinheit 14 verbunden. Sofern der Differenzwert zwischen dem Berechnungswert $U_C$ und der gemessenen Messspannung $U_S$ einen vordefinierten Schwellenwert übersteigt, wird ein entsprechendes Abschaltsignal über die Signalleitung 42 an die Steuereinheit 14 übertragen und die steuerbaren Schalter der Halbbrücken werden geöffnet, um den Antrieb 12 stromlos zu schalten.

Die zweite Prüfeinheit 38 überträgt den berechneten Gesamtstrom $I_V$ an die erste Prüfeinheit 36 und die erste Prüfeinheit 36 ermittelt anhand des Widerstandswerts $R_S$ des Messwiderstands 22 den Berechnungswert $U_C$ und vergleicht unabhängig von der zweiten Prüfeinheit 38 den Berechnungswert $U_C$ mit der gemessenen Messspannung $U_S$. Die erste Prüfeinheit ist über eine Signalleitung 40 mit einem Schalter 35 in der Verbindungsleitung verbunden. Sofern der Differenzwert zwischen der Messspannung $U_S$ und dem Berechnungswert $U_C$ einen vordefinierten Schwellenwert übersteigt, wird ein entsprechendes Abschaltsignal an den steuerbaren Schalter 35 übertragen und der steuerbare Schalter 35 entsprechend geöffnet.

Die erste Prüfeinheit 36 und die zweite Prüfeinheit 38 sind vorzugsweise räumlich voneinander getrennt und tauschen wie in Fig. 2 dargestellt die berechneten und gemessenen Daten über ein Bussystem 44 oder ein Sicherheitsbussystem 44 aus. Durch die räumliche Trennung kann eine weitere Redundanz aufgebaut werden, so dass im Fehlerfall zwei unabhängige Auswertungen und Abschaltwege für den elektrischen Antrieb 12 vorhanden sind.

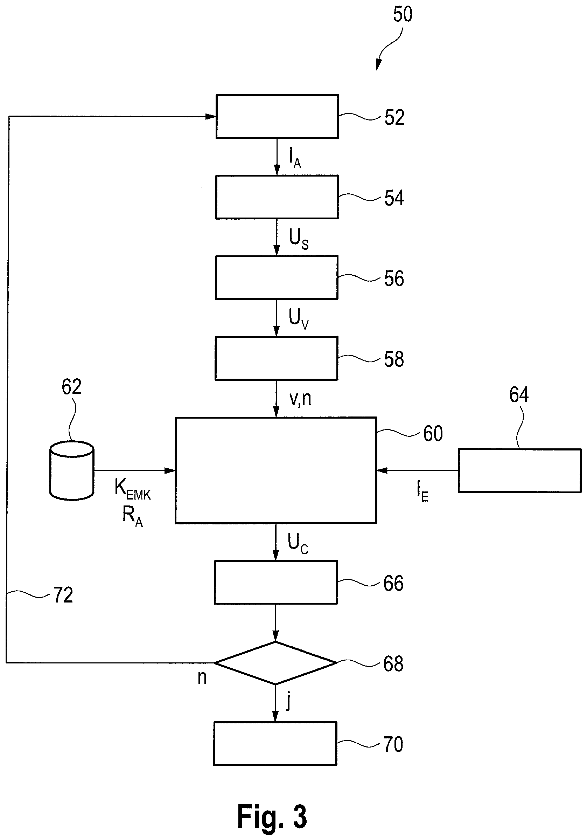

In Fig. 3 ist ein schematisches Ablaufdiagramm eines Verfahrens zum Prüfen einer elektrischen Größe der elektrischen Maschine 10 gezeigt. Das Verfahren ist in Fig. 3 allgemein mit 50 bezeichnet.

Das Verfahren 50 beginnt mit der Messung des Motorstroms $I_A$, wie es bei Schritt 52 gezeigt ist, wobei die Messung des Motorstroms $I_A$ wie oben erläutert abgesichert werden muss für sicherheitsrelevante Anwendungen. Bei Schritt 54 wird die Messspannung $U_S$ über den Messwiderstand 22 gemessen und der Gesamtstrom $I_V$ bestimmt. Bei Schritt 56 wird die Eingangsspannung $U_V$ gemessen oder für den Fall, dass die Eingangsspannung stabil und konstant ist, bereitgestellt. Bei Schritt 58 wird die Bewegungsgröße des Läufers erfasst, die je nach Ausführungsform des elektrischen Antriebs 12 die Läufergeschwindigkeit v oder die Drehzahl n ist.

Bei Schritt 60 wird auf der Grundlage des Leistungsmodells der elektrischen Maschine 10 der Berechnungswert $U_C$ bestimmt. Für die Berechnung des Berechnungswert $U_C$ werden Motorkonstanten wie $K_{EMK}$ und $R_A$ von einem Speicher 62 bereitgestellt sowie die vorab gemessene Stromaufnahme $I_E$ bereitgestellt, wie es bei 64 gezeigt ist. Bei Schritt 66 wird der Berechnungswert $U_C$ mit der gemessenen Messspannung $U_S$ verglichen. Der so ermittelte Vergleichswert wird bei Schritt 68 mit einem Schwellenwert verglichen und sofern der Vergleichswert größer als der Schwellenwert ist, wird bei Schritt 70 die elektrische Maschine 10 von der elektrischen Energieversorgung getrennt bzw. der elektrische Antrieb 12 stromlos geschaltet. Sofern der Vergleichswert kleiner ist als der vordefinierte Schwellenwert, kehrt das Verfahren 50 zum Schritt 52 zurück, wie es durch die Rückkopplung 72 gezeigt ist und erfasst den Motorstrom $I_A$.

Es versteht sich, dass die Schritte 52 bis 58 auch parallel oder in einer beliebigen anderen Reihenfolge erfolgen können und dass das Verfahren 50 kontinuierlich ablaufen kann.

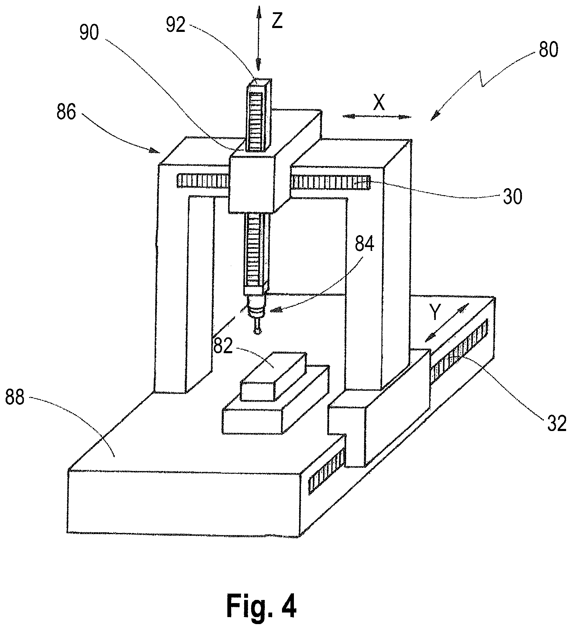

In Fig. 4 ist ein Koordinatenmessgerät als Anwendungsbeispiel für die elektrische Maschine 10 dargestellt und allgemein mit 80 bezeichnet. Das Koordinatenmessgerät 80 dient zum Vermessen eines Werkstücks 82 und weist einen taktilen Sensor 84 zur Vermessung des Werkstücks 82 auf. Das Koordinatenmessgerät 80 weist eine Trägerstruktur 86 auf, die in Y-Richtung relativ zu einer Grundplatte 88 bewegbar ist. Die Trägerstruktur 86 weist ferner einen Schlitten 90 und eine Pinole 92 auf, die jeweils beweglich gelagert sind und mittels elektrischen Antrieben verfahrbar sind. Die Trägerstruktur 86 sowie der Schlitten 90 und die Pinole 92 können mittels einer elektrischen Maschine 10 gemäß der vorliegenden Erfindung angetrieben werden. Durch die Absicherung des Motorstroms $I_A$ können die Antriebskräfte der einzelnen Elemente sicher begrenzt werden.

## Patentansprüche

1. Verfahren (50) zum Prüfen eines Antriebsstroms ($I_A$) einer elektrischen Maschine (10), insbesondere einer elektrischen Maschine (10) eines Koordinatenmessgeräts (80), wobei die elektrische Maschine (10) eine Steuereinheit (14) und einen elektrischen Antrieb (12) mit einem Ständer und einem Läufer aufweist, wobei die Steuereinheit den Ständer mit dem Antriebsstrom bestromt, mit den Schritten:

   - Erfassen (52) eines Wertes des Antriebsstroms ($I_A$), der zum Antreiben des Läufers dem elektrischen Antrieb (12) zugeführt wird,
   - Erfassen (54) eines Messwertes ($U_S$) einer elektrischen Eingangsgröße der elektrischen Maschine (10), wobei die elektrische Eingangsgröße ein von der elektrischen Maschine (10) aufgenommener Gesamtstrom ($I_V$) oder eine dem von der elektrischen Maschine (10) aufgenommenen Gesamtstrom ($I_V$) entsprechende elektrische Größe ($U_S$) ist,
   - Bestimmen (60) eines Berechnungswertes ($U_C$) auf der Grundlage des erfassten Wertes des Antriebsstroms ($I_A$) und eines Leistungsmodells der elektrischen Maschine (10), und
   - Bestimmen (68) eines Vergleichswertes auf der Grundlage des erfassten Messwertes ($U_S$) und des bestimmten Berechnungswerts ($U_C$) der elektrischen Eingangsgröße, um den erfassten Wert des Antriebsstroms ($I_A$) zu prüfen,

   **dadurch gekennzeichnet, dass** der Berechnungswert ($U_C$) ein berechneter Wert der elektrischen Eingangsgröße ist, wobei der Vergleichswert auf der Grundlage eines Differenzwerts zwischen dem Messwert ($U_S$) und dem Berechnungswert ($U_C$) der elektrischen Eingangsgröße bestimmt wird.

2. Verfahren nach Anspruch 1, wobei der Berechnungswert ($U_C$) der elektrischen Eingangsgröße auf der Grundlage einer der elektrischen Maschine (10) bereitgestellten Gesamtspannung ($U_V$) berechnet wird.

3. Verfahren nach Anspruch 1 oder 2, wobei das Leistungsmodell eine elektromagnetische Kraft des elektrischen Antriebs (12) berücksichtigt.

4. Verfahren nach Anspruch 3, wobei eine Bewegungsgröße (v, n) des Läufers erfasst wird und wobei die elektromagnetische Kraft auf der Grundlage einer Kenngröße des elektrischen Antriebs (12) und der erfassten Bewegungsgröße (v, n) bestimmt wird.

5. Verfahren nach einem der Ansprüche 1 bis 4, wobei das Leistungsmodell eine elektrische Verlustleistung ($P_E$) einer Steuereinheit (14) der elektrischen Maschine (10) berücksichtigt.

6. Verfahren nach 5 6, wobei die elektrische Verlustleistung ($P_E$) der Steuereinheit (14) bei stillstehendem Läufer bestimmt wird.

7. Verfahren nach einem der Ansprüche 1 bis 6, wobei das Leistungsmodell eine mechanische Antriebsleistung ($P_M$) des elektrischen Antriebs berücksichtigt.

8. Verfahren nach einem der Ansprüche 1 bis 7, wobei der Vergleichswert auf der Grundlage einer Summe einer Mehrzahl der Differenzwerte bestimmt wird.

9. Verfahren nach einem der Ansprüche 1 bis 7, wobei der Vergleichswert auf der Grundlage eines Integrals des Differenzwerts bestimmt wird.

10. Verfahren nach Anspruch 8 oder 9, wobei ein vordefinierter Wert von einem Wert des Integrals oder einem Wert der Summe subtrahiert wird.

11. Verfahren zum Betreiben einer elektrischen Maschine (10), mit den Schritten:

    - Prüfen eines Antriebsstroms ($I_A$) der elektrischen Maschine (10) gemäß dem Verfahren nach einem der Ansprüche 1 bis 10, und
    - Unterbrechen einer elektrischen Energieversorgung des elektrischen Antriebs (12), sofern der Vergleichswert einen vordefinierten Schwellenwert überschreitet.

12. Vorrichtung (30) zum Prüfen eines Antriebsstroms ($I_A$) einer elektrischen Maschine (10), insbesondere einer elektrischen Maschine (10) eines Koordinatenmessgeräts (80), wobei die elektrische Maschine (10) eine Steuereinheit (14) und einen elektrischen Antrieb (12) mit einem Ständer und einem Läufer aufweist, wobei die Steuereinheit den Ständer mit dem Antriebsstrom bestromt, mit:

    - einer ersten Erfassungseinheit, die dem elektrischen Antrieb (12) zugeordnet ist und dazu ausgebildet ist, einen Wert des Antriebsstroms ($I_A$) zu erfassen, der zum Antreiben des Läufers dem elektrischen Antrieb (12) zugeführt wird,
    - einer zweiten Erfassungseinheit (22), die dazu ausgebildet ist, einen Messwert ($U_S$) einer elektrischen Eingangsgröße der elektrischen Maschine (10) zu erfassen, wobei die elektrische Eingangsgröße ein von der elektrischen Maschine (10) aufgenommener Gesamtstrom ($I_V$) oder eine dem von der elektrischen Maschine (10) aufgenommenen Gesamtstrom ($I_V$) entsprechende elektrische Größe ($U_S$) ist,
    - einer Bestimmungseinheit (32), die dazu ausgebildet ist, einen Berechnungswert ($U_C$) auf der Grundlage des erfassten Antriebsstroms ($I_A$) und eines Leistungsmodells der elektrischen Maschine (10) zu bestimmen, und
    - einer Prüfeinheit (34), die dazu ausgebildet ist, einen Vergleichswert auf der Grundlage des erfassten Messwertes ($U_S$) und des bestimmten Berechnungswertes ($U_C$) der elektrischen Eingangsgröße zu bestimmen, um den erfassten Wert des Antriebsstroms ($I_A$) zu prüfen,

    **dadurch gekennzeichnet, dass** der Berechnungswert ($U_C$) ein berechneter Wert der elektrischen Eingangsgröße ist, wobei die Prüfeinheit (34) den Vergleichswert auf der Grundlage eines Differenzwerts zwischen dem Messwert ($U_S$) und dem Berechnungswert ($U_C$) der elektrischen Eingangsgröße bestimmt.

13. Vorrichtung nach Anspruch 12, wobei die zweite Erfassungseinheit (22) zum Erfassen des Messwertes ($U_S$) der elektrischen Eingangsgröße und die Bestimmungseinheit (32) zum Bestimmen des Berechnungswertes der elektrischen Eingangsgröße mit jeweils einer separaten Prüfeinheit (36, 38) verbunden sind, wobei die Prüfeinheiten (36, 38) jeweils dazu ausgebildet sind, den Vergleichswert unabhängig zu bestimmen, um den erfassten Wert des Antriebsstroms ($I_A$) unabhängig zu prüfen.

14. Vorrichtung nach Anspruch 13, wobei die separaten Prüfeinheiten (36, 38) jeweils mit einer Schalteinheit (35) der elektrischen Maschine (10) verbunden sind, um eine elektrische Energieversorgung des elektrischen Antriebs (12) zu unterbrechen.

15. Elektrische Maschine (10) mit einem elektrischen Antrieb (12), der einen Ständer und einen Läufer aufweist, einer Steuereinheit (14) zum Ansteuern bzw. Bestromen des elektrischen Antriebs (12), und mit einer Vorrichtung (30) zum Prüfen eines Antriebsstroms ($I_A$) nach einem der Ansprüche 12 bis 14.

**Claims**

1. Method (50) for checking a drive current ($I_A$) of an electric machine (10), in particular an electric machine (10) of a coordinate measuring machine (80), wherein the electric machine (10) has a control unit (14) and an electric drive (12) having a stator and a rotor, wherein the control unit energizes the stator by means of the drive current, having the steps of:

    - detecting (52) a value of the drive current ($I_A$), which is fed to the electric drive (12) for the purpose of driving the rotor,
    - detecting (54) a measurement value ($U_C$) of an electrical input variable of the electric machine (10), wherein the electrical input variable is a total current ($I_V$) consumed by the electric machine (10) or an electrical variable ($U_S$) corresponding to the total current ($I_V$) consumed by the electric machine (10),
    - determining (60) a calculation value ($U_C$) on the basis of the detected value of the drive current ($I_A$) and of a performance model of the electric machine (10), and
    - determining (68) a comparison value on the basis of the detected measurement value ($U_S$) and of the determined calculation value ($U_C$) of the electrical input variable, in order to check the detected value of the drive current ($I_A$),
    - **characterized in that** the calculation value ($U_C$) is a calculated value of the electrical input variable, wherein the comparison value is determined on the basis of a difference value between the measurement value ($U_S$) and the calculation value ($U_C$) of the electrical input variable.

2. Method according to Claim 1, wherein the calculation value ($U_C$) of the electrical input variable is calculated on the basis of a total voltage ($U_V$) supplied to the electric machine (10).

3. Method according to Claim 1 or 2, wherein the performance model takes an electromagnetic force of the electric drive (12) into account.

4. Method according to Claim 3, wherein a movement variable (v, n) of the rotor is detected and wherein the electromagnetic force is determined on the basis of a characteristic variable of the electric drive (12) and of the detected movement variable (v, n).

5. Method according to one of Claims 1 to 4, wherein the performance model takes an electrical power loss ($P_E$) of a control unit (14) of the electric machine (10) into account.

6. Method according to Claim 5, wherein the electrical power loss ($P_E$) of the control unit (14) is determined when the rotor is stationary.

7. Method according to one of Claims 1 to 6, wherein the performance model takes a mechanical drive power ($P_M$) of the electric drive into account.

8. Method according to one of Claims 1 to 7, wherein the comparison value is determined on the basis of a sum of a plurality of the difference values.

9. Method according to one of Claims 1 to 7, wherein the comparison value is determined on the basis of an integral of the difference value.

10. Method according to Claim 8 or 9, wherein a predefined value is subtracted from a value of the integral or a value of the sum.

11. Method for operating an electric machine (10), having the steps of:

- checking a drive current ($I_A$) of the electric machine (10) in accordance with the method according to one of Claims 1 to 10, and
- interrupting an electrical power supply of the electric drive (12) if the comparison value exceeds a predefined threshold value.

12. Apparatus (30) for checking a drive current ($I_A$) of an electric machine (10), in particular an electric machine (10) of a coordinate measuring machine (80), wherein the electric machine (10) has a control unit (14) and an electric drive (12) having a stator and a rotor, wherein the control unit energizes the stator by means of the drive current, having:

- a first detection unit, which is associated with the electric drive (12) and is configured to detect a value of the drive current ($I_A$), which is fed to the electric drive (12) for the purpose of driving the rotor,
- a second detection unit (22), which is configured to detect a measurement value ($U_S$) of an electrical input variable of the electric machine (10), wherein the electrical input variable is a total current ($I_V$) consumed by the electric machine (10) or an electrical variable ($U_S$) corresponding to the total current ($I_V$) consumed by the electric machine (10),
- a determination unit (32), which is configured to determine a calculation value ($U_C$) on the basis of the detected drive current ($I_A$) and of a performance model of the electric machine (10), and
- a checking unit (34), which is configured to determine a comparison value on the basis of the detected measurement value ($U_S$) and of the determined calculation value ($U_C$) of the electrical input variable, in order to check the detected value of the drive current ($I_A$), **characterized in that** the calculation value ($U_C$) is a calculated value of the electrical input variable, wherein the checking unit (34) determines the comparison value on the basis of a different value between the measurement value ($U_S$) and the calculation value ($U_C$) of the electrical input variable.

13. Apparatus according to Claim 12, wherein the second detection unit (22) for detecting the measurement value ($U_S$) of the electrical input variable and the determination unit (32) for determining the calculation value of the electrical input variable are connected in each case to a separate checking unit (36, 38), wherein the checking units (36, 38) are each configured to independently determine the comparison value in order to independently check the detected value of the drive current ($I_A$).

14. Apparatus according to Claim 13, wherein the separate checking units (36, 38) are connected in each case to a switching unit (35) of the electric machine (10) in order to interrupt an electrical power supply of the electric drive (12).

15. Electric machine (10) having an electric drive (12), which has a stator and a rotor, having a control unit (14) for actuating or energizing the electric drive (12) and having an apparatus (30) for checking a drive current ($I_A$) according to one of Claims 12 to 14.

**Revendications**

1. Procédé (50) pour tester un courant d'entraînement ($I_A$) d'une machine électrique (10), en particulier d'une machine électrique (10) d'un appareil de mesure de coordonnées (80), dans lequel la machine électrique (10) comporte une unité de commande (14) et un dispositif d'entraînement électrique (12) pourvu d'un stator et d'un rotor, dans lequel l'unité de commande alimente le stator avec le courant d'entraînement, comprenant les étapes consistant à :

- détecter (52) une valeur du courant d'entraînement ($I_A$), qui est fourni au dispositif d'entraînement électrique (12) pour entraîner le rotor,
- détecter (54) une valeur de mesure ($U_S$) d'une grandeur d'entrée électrique de la machine électrique (10), dans lequel la grandeur d'entrée électrique est un courant total ($I_V$) prélevé par la machine électrique (10) ou une grandeur électrique ($U_S$) correspondant au courant total ($I_V$) prélevé par la machine électrique (10),
- déterminer (60) une valeur calculée ($U_C$) sur la base de la valeur détectée du courant d'entraînement ($I_A$) et d'un modèle de puissance de la machine électrique (10), et
- déterminer (68) une valeur de comparaison sur la base de la valeur de mesure détectée ($U_S$) et de la valeur de calcul déterminée ($U_C$) de la grandeur d'entrée électrique pour tester la valeur détectée du courant d'entraînement ($I_A$),

**caractérisé en ce que** la valeur calculée ($U_C$) est une valeur calculée de la variable d'entrée électrique, dans lequel la valeur de comparaison est déterminée sur la base d'une valeur de différence entre la valeur de mesure ($U_S$) et la valeur calculée ($U_C$) de la grandeur d'entrée électrique.

2. Procédé selon la revendication 1, dans lequel la valeur calculée ($U_C$) de la grandeur d'entrée électrique est calculée sur la base d'une tension totale ($U_V$) fournie à la machine électrique (10).

3. Procédé selon la revendication 1 ou 2, dans lequel le modèle de puissance prend en compte une force électromagnétique du dispositif d'entraînement électrique (12).

4. Procédé selon la revendication 3, dans lequel une grandeur de mouvement (v, n) du rotor est détectée, et dans lequel la force électromagnétique est déterminée sur la base d'une grandeur caractéristique du dispositif d'entraînement électrique (12) et de la grandeur de mouvement détectée (v, n).

5. Procédé selon l'une des revendications 1 à 4, dans lequel le modèle de puissance prend en compte une perte de puissance électrique ($P_E$) d'une unité de commande (14) de la machine électrique (10).

6. Procédé selon 5 6, dans lequel la perte de puissance électrique ($P_E$) de l'unité de commande (14) est déterminée lorsque le rotor est à l'arrêt.

7. Procédé selon l'une des revendications 1 à 6, dans lequel le modèle de puissance prend en compte une puissance d'entraînement mécanique ($P_M$) du dispositif d'entraînement électrique.

8. Procédé selon l'une des revendications 1 à 7, dans lequel la valeur de comparaison est déterminée sur la base de la somme d'une pluralité des valeurs de différence.

9. Procédé selon l'une des revendications 1 à 7, dans lequel la valeur de comparaison est déterminée sur la base d'une intégrale de la valeur de différence.

10. Procédé selon la revendication 8 ou 9, dans lequel une valeur prédéfinie est soustraite à une valeur de l'intégrale ou à une valeur de la somme.

11. Procédé pour le fonctionnement d'une machine électrique (10), comprenant les étapes consistant à :

- tester un courant d'entraînement ($I_A$) de la machine électrique (10) conformément au procédé selon l'une des revendications 1 à 10, et
- interrompre l'alimentation électrique du dispositif d'entraînement électrique (12) si la valeur de comparaison dépasse une valeur de seuil prédéfinie.

12. Dispositif (30) destiné à tester un courant d'entraînement ($I_A$) d'une machine électrique (10), en particulier d'une machine électrique (10) d'un appareil de mesure de coordonnées (80), dans lequel la machine électrique (10) comporte une unité de commande (14) et un dispositif d'entraînement électrique (12) pourvu d'un stator et d'un rotor, dans lequel l'unité de commande alimente le stator avec le courant d'entraînement, comportant :

- une première unité de détection associée au dispositif d'entraînement électrique (12) et conçue pour détecter une valeur du courant d'entraînement ($I_A$) fourni au dispositif d'entraînement électrique (12) pour entraîner le rotor,
- une seconde unité de détection (22) conçue pour détecter une valeur de mesure ($U_S$) d'une grandeur d'entrée électrique de la machine électrique (10), dans lequel la grandeur d'entrée électrique est un courant total ($I_V$) prélevé par la machine électrique (10) ou une grandeur électrique ($U_S$) correspondant au courant total ($I_V$) prélevé par la machine électrique (10),
- une unité de détermination (32) conçue pour déterminer une valeur calculée ($U_C$) sur la base du courant d'entraînement détecté ($I_A$) et d'un modèle de puissance de la machine électrique (10), et

- une unité de test (34) conçue pour déterminer une valeur de comparaison sur la base de la valeur de mesure ($U_S$) détectée et de la valeur calculée ($U_C$) déterminée de la grandeur d'entrée électrique afin de tester la valeur détectée du courant d'entraînement ($I_A$),

**caractérisé en ce que** la valeur calculée ($U_C$) est une valeur calculée de la grandeur d'entrée électrique, dans lequel l'unité de test (34) détermine la valeur de comparaison sur la base d'une valeur de différence entre la valeur de mesure ($U_S$) et la valeur calculée ($U_C$) de la grandeur d'entrée électrique.

13. Dispositif selon la revendication 12, dans lequel la seconde unité de détection (22) destinée à détecter la valeur de mesure ($U_S$) de la grandeur d'entrée électrique et l'unité de détermination (32) destinée à déterminer la valeur calculée de la grandeur d'entrée électrique sont respectivement reliées à une unité de test (36,38) séparée, dans lequel les unités de test (36, 38) sont respectivement conçues pour déterminer indépendamment la valeur de comparaison afin de tester indépendamment la valeur détectée du courant de commande ($I_A$).

14. Dispositif selon la revendication 13, dans lequel les unités de test (36, 38) séparées sont respectivement reliées à une unité de commutation (35) de la machine électrique (10) pour interrompre une alimentation en énergie électrique du dispositif d'entraînement électrique (12).

15. Machine électrique (10) comprenant un dispositif d'entraînement électrique (12) qui comporte un stator et un rotor, une unité de commande (14) destinée à commander ou alimenter en courant le dispositif d'entraînement électrique (12), et comprenant un dispositif (30) destiné à tester un courant d'entraînement ($I_A$) selon l'une des revendications 12 à 14.

**Fig. 1**

**Fig. 2**

**Fig. 3**

**Fig. 4**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2063333 A1
- DE 102006003362 A1
- DE 102001075387 A1
- US 20050218849 A
- US 20080094762 A1